Europäisches Patentamt

European Patent Office

Office européen des brevets

(11) Publication number: **0 109 084**
**B1**

(12) **EUROPEAN PATENT SPECIFICATION**

(45) Date of publication of patent specification: **10.06.87**

(21) Application number: **83111383.2**

(22) Date of filing: **14.11.83**

(51) Int. Cl.⁴: **H 05 K 3/42, H 05 K 3/12**

(54) A method of making a double-sided thick-film integrated circuit.

(30) Priority: **15.11.82 DK 5087/82**

(43) Date of publication of application:
**23.05.84 Bulletin 84/21**

(45) Publication of the grant of the patent:
**10.06.87 Bulletin 87/24**

(84) Designated Contracting States:
**CH DE FR GB IT LI NL SE**

(56) References cited:
**US-A-3 346 950**
**US-A-3 969 815**
**US-A-4 017 968**

(73) Proprietor: **STORNO A/S**
**Artillerivej 126**
**DK-2300 Copenhagen S (DK)**

(72) Inventor: **Hvims, Henrik Laurits**
**Osterlaagen 3**
**DK-2700 Bronshoj (DK)**

(74) Representative: **Patentanwälte Grünecker, Dr.**
**Kinkeldey, Dr. Stockmair, Dr. Schumann, Jakob,**
**Dr. Bezold, Meister, Hilgers, Dr. Meyer-Plath**
**Maximilianstrasse 58**
**D-8000 München 22 (DE)**

Courier Press, Leamington Spa, England.

## Description

The present invention relates to a method of making a double-sided thick-film integrated circuit. Such integrated circuits may be made by applying a conductive viscous liquid substance or ink to opposite sides of a plate-shaped thick-film substrate of a ceramic material in patterns defining the circuits desired. The conductive substance is normally applied by alternating screen printing and drying processes. Usually, it is desired to provide conductive interconnections between circuits on the opposite sides of the substrate, and in order to avoid an undesired resistance increase at high frequencies, such interconnections should be as short as possible.

From US—A—3346950 a method for establishing small area through connections between conductors disposed on opposite faces of an insulator is disclosed in which at desired points of interconnection a small area of a copper conductor on one surface of the insulator body is depressed into and through the adjacent insulator material into contact with a point on a copper conductor on the opposite surface of the insulator body. The opposite conductor is backed by a supporting plate to arrest the movement of the depressing tool at its inner surface. The depressing tool is shaped to exert a stressing force on the depressed copper conductor to a point beyond the elastic limit of the material such that the worked copper material of this conductor is capable of withstanding the tendency of the displaced insulator material to relax into its former position after removal of the depressing tool. This technique is not suitable to be applied to thick-film integrated circuits due to the type of conducting material used in such circuits.

From US—A—4017968, a method of making plated through hole printed circuit boards is known according to which a resist coating is applied uniformly over both planar surfaces of the circuit board on which the circuit elements have already been formed from copper by a photoresist and etching technique. The portions of the conductors contacting the edge portions of the through holes in the board are mechanically depressed into the substrate to form counter-sink areas. Thereby, the resist coating covering the depressed conductor element portions are removed so that the surfaces of the peripheral circuit portions at the through holes are exposed. Thereafter a conductive coating is applied, either by an electroless process or electrolytically to form a plated through hole connection connecting the exposed peripheral conductor portions with each other. Then, the resist material is removed by using a solvent. As in the aforementioned case, this method is not applicable with thick-film integrated circuits due to the different characteristics of the conductive material used in such circuits.

Concerning thick-film integrated circuits, it is known to provide such short interconnections by forming one or more straight, through bores in a thick-film substrate at selected points thereof prior to applying a conductive substance thereto. During the printing operation or operations conductive substance or ink is introduced into the bore or bores so as to establish a conductor extending through each bore and interconnecting the printing circuits on the opposite sides of the substrate. In order to prevent an excessive amount of the conductive substance from flowing through each bore during the printing of one side of the substrate and smudges the opposite side, the bores must have a rather small diameter and are therefore normally made by laser beams. In order to secure that an amount of the conductive substance sufficient to establish contact between the opposite sides of the substrate, is introduced into the very thin bores during a printing operation, the substrate is placed on a suction box so as to establish a pressure difference between the opposite sides of the substrate. In this manner it may be secured that the bore is filled with the conductive substance in a controlled manner. In order to secure contact with a circuit which is subsequently printed on the side of the substrate facing the suction box, the conductive substance must be sucked right through the bore so that the risk of smearing the substance renders it impossible to transport the substrate by means of conveyor belts, until the conductive substance has been dried, and, consequently, the use of special handling equipment is necessary.

The present invention provides a method making it possible to produce double-sided thick-film integrated circuits by using conventional printers and unloaders.

Thus, the present invention provides a method of making a double-sided thick-film integrated circuit, said method comprising

providing in a thick-film substrate at least one through bore including at least one widened end portion and a portion defining a throat therein,

applying to a first side surface of the substrate a first pattern of a liquid conductive substance covering the opening of the through bore into said first side surface, and

applying to a second side surface of the substrate opposite to the first side surface a second pattern of a liquid conductive substance covering the opening of the said widened end portion into said second side surface so as to establish conductive contact between the first and second patterns of conductive substance through said bore.

It has been found that an uncontrolled flow of the conductive substance through the bore formed in the substrate can be prevented by a throat — which means a restriction extending along a relatively small axial length of the bore — having a suitably small diameter or cross-sectional area, which may be of substantially the same order as the diameter or the cross-sectional area of the conventional straight bores. Furthermore, the small axial extension of the throat makes it possible to completely fill the bore by the screen printing operations on both sides of the substrate without the necessity of providing a pressure difference between the opposite side surfaces of the substrate. The throat may be located at any position along the axial length of the through bore, and as only a very small amount of conductive substance penetrates the throat during a screen printing operation of one side of the substrate, the risk of smearing the substance on the opposite side of the substrate during handling thereof may be avoided.

The throat of the through bore may be located between two widened end portions of the bore. In this case, it is less important which one of the opposite side surfaces of the substrate is printed at first. The widenings at the opposite ends of the bore may have any cross-sectional shape, for example a cylindrical, conical, or spherical shape. In the preferred embodiment, however, the cross-sectional area of the widened end portions is decreasing from the outer side surfaces of the substrate towards the throat so that the bore is substantially hourglass-shaped.

According to an alternative embodiment the throat is located closely adjacent to the said first side surface of the substrate, which is the side surface to which conductive substances is applied at first. When the substance applied to the first surface has been dried, and a pattern of conductive substance is applied to the opposite or second side surface by screen printing, the widened end portion of the bore is automatically filled up with conductive substance so as to establish contact between the printed circuits on the opposite sides of the substrate. In a preferred embodiment the bore may be funnel-shaped and may, for example be in the form of a truncated cone. However, also in this case the widened end portion may have any other shape, such as cylindrical or spherical.

The bore in the substrate may be made in any suitable manner. In the preferred embodiment, however, the bore is made by making a straight bore with a diameter corresponding to that of the throat, for example by means of a laser beam, and subsequently widening the end portion or portions of the straight bore by means of a grinding tool. It is envisaged, however, that it is also possible to make the bore in its final shape by a laser drilling or laser shooting technique.

The diameter or cross-sectional area of the throat must be adapted to the viscosity of the conductive substance or ink so that during screen printing of the first side surface of the substrate a very small amount of the substance is squeezed through the throat without being able to flow freely therethrough.

Normally, the substrate is made from a wet ceramic material which is formed into small plates or sheets in its wet condition and therafter hardened by firing. In the known methods the through bores are provided in the substrate after firing and before printing. According to the present invention the bore may be formed, for example by punching, while the substrate is in a rather soft condition, for example after drying the wet ceramic material, but prior to firing.

According to another aspect the present invention also relates to a double-sided thick-film integrated circuit comprising
a thick-film substrate defining therein at least one through bore including at least one widened end portion and a portion defining a throat therein,
patterns of conductive substance applied to opposite side surfaces of the substrate, and
a connecting portion of the conductive substance extending through said bore and interconnecting said patterns.

The present invention also provides a method of making such a thick-film substrate by forming the thick-film from a wet deformable ceramic material, drying the wet substrate, forming the bore in the dried substrate, and subsequently firing the substrate thus formed to harden it.

The invention will now be further described with reference to the drawings, wherein

Fig. 1 is a sectional view illustrating a screen printing process in which a conductive ink-like substance is applied to one side of a thick-film substrate having a through, hourglass-shaped bore therein,

Fig. 2 is a sectional view illustrating a screen printing process, in which a conductive substance is applied to the opposite side of the substrate,

Fig. 3 is a sectional view of the substrate after drying of the conductive substance,

Fig. 4 illustrates a printing process as that of Fig. 1, but in connection with a substrate having a funnel-shaped bore formed therein,

Fig. 5 is a sectional view of the substrate shown in Fig. 4 after applying conductive substance to both sides thereof and after drying the substance, and

Fig. 6 is a sectional view of a substrate having another type of a funnel-shaped bore formed therein.

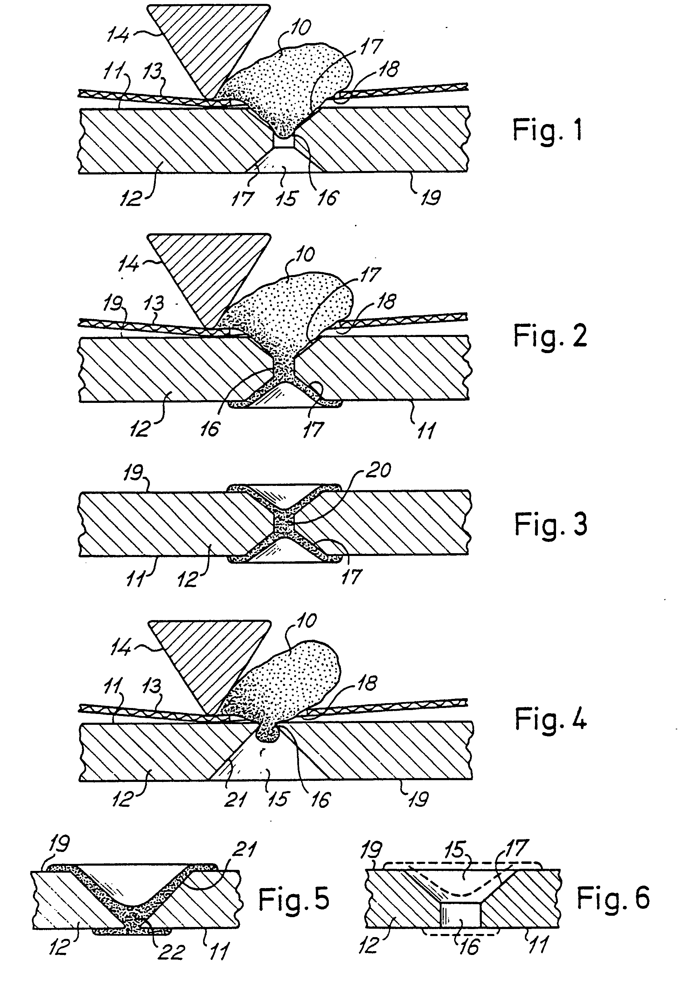

Figs. 1—3 illustrate a method of making a double-sided thick-film integrated circuit. Fig. 1 shows a pattern of a viscous conductive ink-like substance 10 being applied to a first side surface 11 of a plate-shaped conventional thick-film substrate 12 by a conventional screen printing technique. The screen printing is made by means of a screen 13 having cut-outs 18 therein corresponding to the said pattern, and by means of a squeegee 14. The substrate 12 has one or more through bores 15 formed therein, and each bore 15 (only one bore is shown in the drawings) is formed with a throat 16. In the embodiment shown in Figs. 1—3 the bore 15 is hourglass-shaped and has widened end portions 17 on either side of the throat 16. The size of the widened end portions 17 is such that the widened end portion adjacent to the screen 13 will be filled with the viscous, paste-like substance 10 when this substance is pushed along the outer surface of the screen 13 and over the opening 18 therein by the squeegee 14 during the printing operation. Furthermore, the cross-sectional area and the axial length of the throat 16 is adapted to the viscosity of the substance 10 so that during the printing operation the substance is squeezed into the throat 16, but will not flow through the same, vide Fig. 1.

When the print of conductive substance made on the first side surface 11 of the substrate 12 has been dried, the substrate is turned, and a desired circuit or pattern is printed on the opposite second side surface 19 of the substrate 12 by a similar conventional printing process using a screen 13 having cutouts 18 therein corresponding to the desired pattern, vide Fig. 2. Normally, patterns printed on the opposite sides of the substrate 12 are different. However, the two patterns or circuits comprise oppositely arranged points on the axis of the bore 15 which points are intended to be interconnected by a conductive interconnection 20. When the pattern is printed on the second side surface of the substrate 12 as illustrated in Fig. 2, the adjacent widened end portion 17 is filled with the conductive substance 10 which is also squeezed into the throat 16 and united with substance 10 introduced into the throat from the other side of the substrate, so as to form the desired interconnection 20 of the circuits printed on opposite sides of the substrate 12. During a subsequent drying process the ink or substance 10 will shrink so that the final shape of the dried substance in the bore 15 will be as illustrated in Fig. 3.

Figs. 4 and 5 show a substrate 12 with a substantially cone-or funnel-shaped bore 15 comprising a throat 16 positioned closely adjacent to the first side surface 11, and a widened or funnel-shaped portion 21 located adjacent to the second side surface 19 of the substrate 12.

During printing of the first side surface 11 the substance 10 is squeezed through the adjacent throat 16 so as to form a bead at the inner part of the widened or funnel-shaped portion 21. During printing of the opposite second side surface 19 of the substrate 12 the widened portion 21 of the bore 15 is filled with substance 10 so as to provide a conductive interconnection 22 between the circuits on the opposite sides of the substrate 12. After drying the substance introduced into the bore 15 will have obtained a shape substantially as shown in Fig. 5.

Fig. 6 shows a fragmentary sectional view of a thick-film substrate 12 with a modified funnel-shaped bore 15. In Fig. 6 the throat 16 at the first side surface 11 of the substrate is part of a cylindrical bore having a widened end portion 17 at the opposite second side surface 12. When the substrate has been printed with a conductive substance in a manner described above, the dry conductive substance may have a shape as indicated with broken lines in Fig. 6.

If the substrate 12 is made from a ceramic material or a similar hard material the through bores 15 may be made in two stages. Firstly, a straight cylindrical bore with a diameter corresponding to that of the gorge or throat 16 may be made by laser beams, and, subsequently, the widened end portion or portions 17 and 21 may be made by grinding, for example by means of a diamond tool. Alternatively, it is possible to form the through bores 15 in the substrate 12 by suitable tools while the substrate is still in a soft or plastic condition, prior to firing the ceramic material.

### Example 1

A standard type thick-film substrate of a ceramic material containing 96% of aluminum oxide was provided with through bores of the type shown in Figs. 1—3. The thickness of the substrate was 0.63 mm, and through bores with a diameter of 0.4 mm were made in the substrate by laser beam shooting. Each bore was provided with widened end portions by means of a spherical diamond grinding tool so as to provide widened end portions with spherical surfaces. The axial length of the throat defined between the widened end portions was approximately 0.1 mm, and the diameter of the widened end portions at the opposite side surfaces of the substrate was approximately 1 mm. Patterns of commercially available a palladium/silver conductor composition were applied to the opposite side surfaces of the substrate by a conventional screen printing side surfaces of the substrate by a conventional screen printing technique without using any vacuum. Reliable conductive interconnections of the printed circuits on the opposite sides of the substrate were formed through the bores, and during the printing operation of the first side surface of the substrate, the conductor composition did not flow right through the bores in the substrate, so that no smudging of the lower side of the substrate occurred.

### Example 2

The procedure described in Example 1 was repeated with the modification that a widened, conical end portion was provided only at one end of each through bore so as to provide openings of the type shown in Fig. 6. The axial length of the throat was 0.3 mm, and the maximum diameter of the widened conical end portion at the outer side surface of the substrate was about 1.2 mm. The substrate was printed with a conductive substance as described in Example 1, and the same good result was obtained.

It should be understood that various modifications of the through holes 15 shown in the drawing may be made within the scope of the present invention. Thus, for example, the widened end portions 17 and 21 need not have a tapered section as shown, and may, for example, have a rectangular axial section.

### Claims

1. A method of making a double-sided thick-film integrated circuit, said method comprising:

providing in a thick-film substrate at least one through bore including at least one widened end portion and a portion defining a throat therein,

applying to a first side surface of the substrate a first pattern of a liquid conductive substance covering the opening of the through bore into said first side surface, and

applying to a second side surface of the substrate opposite to the first side surface a second pattern of a liquid conductive substance covering the opening of said widened end portion into said second side surface so as to establish conductive contact between the first and second patterns of conductive substance through said bore.

2. A method according to claim 1, wherein the throat of the through bore is located between two widened end portions of the bore.

3. A method according to claim 2, wherein the bore is substantially hourglass-shaped.

4. A method according to claim 1, wherein the throat defining portion of the bore is located closely adjacent to said first side surface of the substrate.

5. A method according to claim 4, wherein said bore is funnel-shaped.

6. A method according to any of the claims 1 to 5, wherein said bore is made by making a straight bore with a diameter corresponding to that of the throat and subsequently widening the end portion or portions of the straight bore by means of a grinding tool.

7. A method according to any of the claims 1—5, wherein said hole or bore is made in its final shape by a laser drilling technique.

8. A method according to claim 4 or 5, wherein the bore or hole is formed while the substrate is in a rather soft condition.

9. A method according to any of the claims 1—8, said method further comprising

forming the thick-film substrate from a wet, deformable ceramic material, drying the wet substrate,

forming the bore in the dried substrate, and subsequently firing the substrate thus formed to harden the same.

10. A double-sided thick-film integrated circuit comprising

a thick-film substrate defining therein at least one through bore including at least one widened end portion and a portion defining a throat therein,

patterns of conductive substance applied to opposite side surfaces of the substrate, and

a connection portion of the conductive substance extending through said bore and formed integrally with both of said patterns, the substance having been applied to the side surfaces of the substrate in a liquid condition and has solidified in situ.

11. A circuit according to claim 10, wherein the throat of the through bore is located between two widened end portions of the bore.

12. A circuit according to claim 11, wherein the bore is substantially hourglass-shaped.

13. A circuit according to claim 10, wherein the throat is located closely adjacent to said first side surface of the substrate.

14. A circuit according to claim 13, wherein said bore is funnel-shaped.

## Patentansprüche

1. Verfahren zum Herstellen einer doppelseitigen integrierten Dickfilmschaltung, enthaltend:

Ausbilden wenigstens einer Durchgangsbohrung in einem Dickfilmsubstrat, die wenigstens einen aufgeweiteten Endabschnitt und einen eine Verengung ausbildenden Abschnitt darin aufweist,

Aufbringen eines ersten Musters aus einer flüssigen, leitfähigen Substanz auf die erste Seite des Substrats, welche Substanz die Öffnung der Durchgangsbohrung in der ersten Seite bedeckt, und

Aufbringen eines zweiten Musters aus einer flüssigen, leitfähigen Substanz auf die zweite Seite des Substrats entgegengesetzt zur ersten Seite, welche Substanz die Öffnung des aufgeweiteten Endabschnitts in der zweiten Seite bedeckt, um einen leitfähigen Kontakt zwischen den ersten und zweiten Mustern aus leitfähiger Substanz durch die Bohrung herzustellen.

2. Verfahren nach Anspruch 1, bei dem die Verengung der Durchgangsbohrung zwischen zwei aufgeweiteten Endabschnitten der Bohrung liegt.

3. Verfahren nach Anspruch 2, bei dem die Bohrung im wesentlichen uhrglasförmig ist.

4. Verfahren nach Anspruch 1, bei dem der die Verengung ausbildende Abschnitt der Bohrung der ersten Seite des Substrats dicht benachbart liegt.

5. Verfahren nach Anspruch 4, bei dem die Bohrung trichterförmig ist.

6. Verfahren nach einem der Ansprüche 1 bis 5, bei dem die Bohrung in der Weise hergestellt wird, daß man eine geradlinige Bohrung mit einem Durchmesser, der demjenigen der Verengung entspricht, herstellt und anschließend den Endabschnitt oder Endabschnitte der geraden Bohrung mit Hilfe eines Schleifwerkzeugs aufweitet.

7. Verfahren nach einem der Ansprüche 1 bis 5, bei dem das Loch oder die Bohrung mittels einer Laserbohrtechnik in die endgültige Gestalt gebracht wird.

8. Verfahren nach Anspruch 4 oder 5, bei dem die Bohrung oder das Loch ausgebildet wird, während sich das Substrat in einem ziemlich weichen Zustand befindet.

9. Verfahren nach einem der Ansprüche 1 bis 8, weiterhin enthaltend:

Ausbilden des Dickfilmsubstrats aus einem feuchten, verformbaren Keramikmaterial,

Trocknen des feuchten Substrats,

Ausbilden der Bohrung in dem getrockneten Substrat und anschließendes Brennen des so geformten Substrats, um es zu härten.

10. Doppelseitige integrierte Dickfilmschaltung, enthaltend:

eine Dickfilmsubstrat, das darin wenigstens eine Durchgangsbohrung ausbildet, die wenigstens einen aufgeweiteten Endabschnitt und einen Abschnitt aufweist, der eine Verengung darin ausbildet,

Muster aus leitfähiger Substanz, die auf gegenüberliegenden Seiten des Substrats aufgebracht sind, und

einen Verbindungsabschnitt der leitfähigen Substanz, der sich durch die Bohrung erstreckt und integral mit beiden genannten Mustern ausgebildet ist, wobei die Substanz auf die Seitenflächen des Substrats in einem flüssigen Zustand aufgebracht worden ist und sich an Ort und Stelle verfestigt hat.

11. Schaltung nach Anspruch 10, bei der die Verengung der Durchgangsbohrung zwischen zwei aufgeweiteten Endabschnitten der Bohrung gelegen ist.

12. Schaltung nach Anspruch 11, bei der die Bohrung im wesentlichen uhrglasförmig ist.

13. Schaltung nach Anspruch 10, bei der die Verengung der ersten Seitenfläche des Substrats dicht benachbart gelegen ist.

14. Schaltung nach Anspruch 13, bei der die Bohrung trichterförmig ist.

**Revendications**

1. Procédé de fabrication d'un circuit intégré à couche épaisse et à double face, ledit procédé comprenant les étapes consistant à:

— prévoir dans un substrat à couche épaisse au moins un perçage traversant comprenant au moins une partie d'extrémité élargie et une partie définissant une gorge dans celui-ci;

— appliquer sur une première surface du substrat un premier motif d'une substance liquide conductrice, qui couvre l'ouverture du perçage traversant dans ladite première surface; et

— appliquer sur une seconde surface du substrat opposée à la première surface un second motif d'une substance liquide conductrice, qui couvre l'ouverture de ladite partie d'extrémité élargie dans la seconde surface de façon à établir un contact conducteur entre les premier et second motifs de la substance conductrice à travers ledit perçage.

2. Procédé selon la revendication 1, dans lequel la gorge du perçage traversant est située entre deux parties d'extrémité élargies du perçage.

3. Procédé selon la revendication 2, dans lequel le perçage est essentiellement en forme de sablier.

4. Procédé selon la revendication 1, dans lequel la partie du perçage définissant la gorge est située à grande proximité de ladite première surface du substrat.

5. Procédé selon la revendication 4, dans lequel ledit perçage est en forme d'entonnoir.

6. Procédé selon l'une quelconque des revendications 1 à 5, dans lequel ledit perçage est formé en réalisant un perçage droit ayant une diamètre correspondant à celui de la gorge, et en élargissant ensuite la ou les parties d'extrémité du perçage droit à l'aide d'un outil de meulage.

7. Procédé selon l'une quelconque des revendications 1 à 5, dans lequel le perçage est réalisé dans sa forme finale par une technique de perçage au laser.

8. Procédé selon la revendication 4 ou 5, dans lequel le perçage est formé pendant que le substrat est dans un état relativement malléable.

9. Procédé selon l'une quelconque des revendications 1 à 8, ledit procédé comprenant en outre les étapes consistant à:

— former le substrat à couche épaisse à partir d'une matière céramique humide et déformable;

— sécher le substrat humide;

— former le perçage dans le substrat séché et cuire ensuite le substrat ainsi formé pour le durcir.

10. Circuit intégré à couche épaisse et à double face comprenant:

— un substrat à couche épaisse dans lequel est défini au moins un perçage traversant comprenant au moins une partie d'extrémité élargie et une partie définissant une gorge dans celui-ci

— des motifs d'une substance conductrice appliquée sur les surfaces opposées du substrat; et

— une partie de connexion de la substance conductrice s'étendant à travers ledit perçage et formée d'une seul tenant avec les deux motifs, la substance ayant été appliquée sur les surfaces du substrat à l'état liquide et s'étant solidifiée in situ.

11. Circuit selon la revendication 10, dans lequel la gorge du perçage traversant est située entre deux parties d'extrémité élargies du perçage.

12. Circuit selon la revendication 11, dans lequel le perçage est essentiellement en forme de sablier.

13. Circuit selon la revendication 10, dans lequel la gorge est située à grande proximité de ladite première surface du substrat.

14. Circuit selon la revendication 13, dans lequel ledit perçage est en forme d'entonnoir.

Fig. 1

Fig. 2

Fig. 3

Fig. 4

Fig. 5

Fig. 6

1